(19) Europäisches Patentamt
European Patent Office
Office européen des brevets

(11) Publication number: **0 093 202**
**B1**

# (12) EUROPEAN PATENT SPECIFICATION

(45) Date of publication of patent specification: **04.06.86**

(51) Int. Cl.$^4$: **C 08 F 12/16**, G 03 F 7/10

(21) Application number: **82111811.4**

(22) Date of filing: **20.12.82**

## (54) Poly(halostyrene) for negative resists.

(30) Priority: **03.05.82 US 373839**

(43) Date of publication of application:
**09.11.83 Bulletin 83/45**

(45) Publication of the grant of the patent:
**04.06.86 Bulletin 86/23**

(84) Designated Contracting States:
**DE FR GB**

(56) References cited:
**US-A-3 440 229**
**US-A-4 201 570**

(73) Proprietor: **International Business Machines Corporation**
**Old Orchard Road**
**Armonk, N.Y. 10504 (US)**

(72) Inventor: **Hatzakis, Michael**
**12 Hunting Ridge Place**
**Chappaqua New York 10514 (US)**
Inventor: **Liutkus, John Joseph**
**Yorkridge Apartments 3C**
**Yorktown Heights New York 10598 (US)**
Inventor: **Paraszczak, Jurij Rostyslav**
**Cortlandt Place**
**Ossining New York 10562 (US)**
Inventor: **Shaw, Jane Margaret**
**49 Old Sib Road**
**Ridgefield Connecticut 06877 (US)**

(74) Representative: **Hobbs, Francis John**
**IBM United Kingdom Patent Operations Hursley Park**
**Winchester, Hants, SO21 2JN (GB)**

**EP 0 093 202 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates generally to the preparation of negative electron beam resists for photomask fabrication and/or semiconductor device fabrication and more particularly to poly(halostyrene), useful in the preparation of said negative resists.

Briefly, a resist is an adhering layer of a material with patterned openings on a substrate which is used as a mask for etching, either partially or completely through, whereby the substrate is being exposed by the openings in the resist. Generally, resists are categorized as positive or negative.

The formation of positive resist masks from layers of radiation degradable polymers is described, for example, in U.S. Patent No. 3,535,137. In this process, a radiation degradable polymer layer is coated on a substrate and is subjected to patternwise exposure to high energy radiation such as, for example, X rays, deep UV, nuclear radiation or electrons. The irradiated regions of the polymer suffer a decrease in molecular weight and thereby become more rapidly soluble. A developer is then used to preferentially remove the irradiated portions of the layer. The substrate is then subjected to an additive or substractive process such as metallization or etching with the remaining portions of the resist layer acting to protect the substrate from the processing.

Alternatively, a negative resist mask is formed by coating a cross-linkable polymer on a substrate. The polymer is generally applied as a solution in a suitable solvent to the substrate and allowed to dry as a thin film. High energy radiation, such as an electron beam, short wave-length UV light, or X-rays, is permitted to irradiate the surface of the polymer in the desired pattern to form a negative resist by imparting sufficient energy to cross-link the polymer. Cross-linking causes the irradiated portion to be insoluble in certain solvents.

After irradiation is completed, the resist is subjected to a solvent and the non-irradiated portion of the resist is removed, thereby leaving openings in the resist that correspond to the desired pattern. The present invention relates to negative resists.

Prior art negative resist materials have several shortcomings, among which is the difficulty in obtaining sharp images of high resolution. Moreover, deep UV lithography using the wavelength range from 2000 to 3500 Å is receiving considerable attention as a possible economic mass production method of manufacturing ultra fine patterns (about 1 µm) for making VLSI. As these deep UV tools become available, much emphasis is being placed on finding compatible negative resist-materials with high resolution, high contrast and plasma resistance.

Recently, polystyrenes have been receiving renewed attention as electron and X-ray resists, primarily since it has been shown by others that very high contrast can be obtained with high molecular weight polystyrene exposed to electron beams at doses in the range of $10^{-4}$coul/cm$^2$ (100 µ coul/cm$^2$). It has also been shown that the sensitivity of polystyrenes can be considerably improved by physical doping with cross-linking agents and sensitizers or by incorporating such elements at chlorine, bromine or iodine in the polymer chain. In this regard, see, for example J.C. Jagt and A.P.G. Sevriens, Photopolymers Principles — Processes and Materials, SPE Ellenville, NY, p. 152 (1979): T. Tsunoda, et al., Phot. Sci. & Engr., 17(4), 390 (1973); N.A. Weir and T. H. Milkie, J. Poly. Sci. (Chem), 17, 3735 (1979); W. Burlant, et al., J. Poly Sci., 58, 491 (1962); E. D. Reit, Photopolymers Principles — Proceses and Materials, SPE, Ellenville, NY, p. 91 (1979); and H. Shiraishi, et al., Photopolymers Principles — Processes and Materials, SPE, Ellenville, NY, p. 56 (1979). However, this literature illustrates that even though the sensitivity of the polystyrenes was increased in the $10^{-6}$ coul/cm$^2$ range, residues and swelling of the exposed pattern are always experienced when trying to develop a high resolution pattern in a relatively thick resist layer (~ lµm).

The invention provides a new class of negative deep UV resist materials which are highly sensitive and plasma resistant. The negative resist materials are highly sensitive in the deep UV region, particularly between 2000 and 2600Å, forming high contrast negative images that are reactive ion etch (RIE) resistant. The negative resists of the present invention allow high contrast and resolution to be obtained on electron beam exposure leaving no residue in the unexposed region and minimum swelling of the exposed region.

According to the invention there is provided a poly(halostyrene) having the general formula

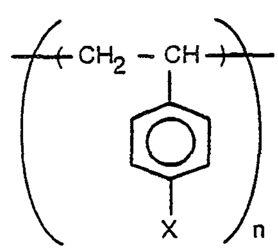

wherein X is chlorine, bromine or iodine, n represents a number in the range of from 750 to 7,500, the molecular weight (Mw) of the polymers being in the range of from $1 \times 10^5$ to $1 \times 10^6$ and the dispersivity

$$\left(\frac{Mw}{Mn}\right)$$

of the polymers being in the range of from 1.5 to 2.5, the poly(halostyrene) having been made by polymerizing halostyrene monomer in a low chain transfer coefficient solvent at a temperature in the range of from 60°C to 100°C for a time of from 2 hours to 1 month and subsequently fractionating the resulting polymer.

The invention will now be described by way of

example with reference to the accompanying drawings in which:—

Fig. 1 is a graphical illustration of the optical absorption of a poly(4-chlorostyrene) resist (1 μm thick) of the present invention at varied wavelengths;

Fig. 2.1 illustrates the contrast curves for poly(4-chlorostyrene) resists of about MW 700,000 (curve A) and about MW 250,000 (curve B), useful in the present invention;

Fig. 2.2 shows scanning electron micrographs of electron beam irradiated poly(4-chlorostyrene) resists in accordance with the present invention;

Fig. 3 shows scanning electron micrographs illustrating the thermal stability of electron beam exposed poly(4-chlorostyrene) resists of the present invention and the almost complete elimination of resist residue by postbaking;

Fig. 4 is a series of scanning electron micrographs illustrating the excellent resolution obtained with electron beam exposed poly(4-chlorostyrene) resists of the present invention; minimum line = 0.4 μm and minimum space = 0.4 μm;

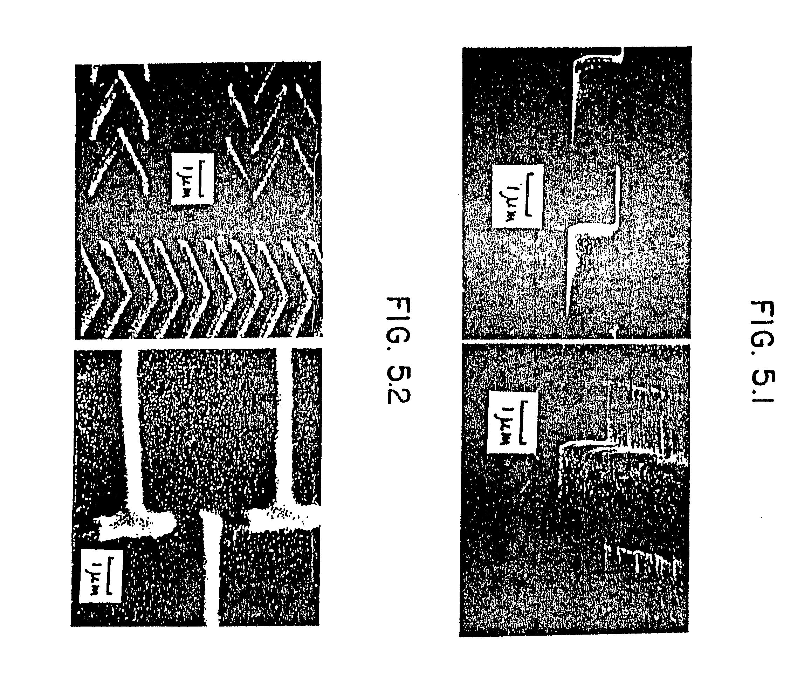

Fig. 5.1 shows scanning electron micrographs illustrating the sharp line profiles obtained on deep UV exposure of poly(4-chlorostyrene) resists of the present invention; and

Fig. 5.2 shows scanning electron micrographs illustrating the narrow patterns obtained on X-ray exposure of poly(4-chlorostyrene) resists of the present invention.

The present invention involves the use of a new class of poly(halogenated styrene), as negative electron beam, X-ray or U.V. resist materials. This new class of poly(halo-styrenes) allows high contrast and high resolution images to be obtained at electron beam exposures of, for example, $1—5 \times 10^{-6}$ coul/cm$^2$, depending on the molecular weight and molecular weight distribution of the polymer, leaving almost no residue in the unexposed region and minimum swelling of the exposed image even at thicknesses above 1 μm.

More specifically, the polymeric compositions which are employed in preparing the resists of the present invention comprise poly(halogenated styrenes) having the following general formula:

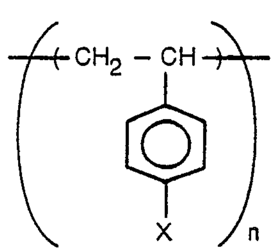

wherein n is a number in the range of from about 750 to about 7,500, X is halogen, such as Cl, Br or I, and wherein the molecular weight distribution of the polymers in the composition results in a dispersivity

$$\left(\frac{Mw}{Mn}\right)$$

of from 1.5 to 2.5. The poly(halogenated styrene) compositions of the present invention generally have a molecular weight (Mw) of from about $1 \times 10^5$ to about $1 \times 10^6$.

Representative halogenated polystyrenes included in the above formula, are, for example, poly(4-chlorostyrene), poly(4-bromostyrene) and poly(4-diodostyrene). Of these, the most preferred for the purposes of this invention is poly(4-chlorostyrene). Preferably, the polymers of the present invention have a molecular weight in the range of from about 250,000 to about 700,000 and a dispersivity in the range of from about 1.7 to about 2.2 and most preferably about 2.

In accordance with the present invention, it has been discovered that the hereinbefore-identified poly(halogenated styrenes) must be prepared by free radical solution polymerization of the monomer in order to achieve the negative resist characteristics desired herein. In contrast to preparing the halogenated polystyrene polymers by bulk polymerization, solution polymerization is believed to result in forming less branching. Branching is deleterious since it may cause swelling of the cross-linked portions on development. Moreover, in the preparation of the poly(halostyrenes) herein, it has been found advantageous to carry out the solution polymerization at a slow rate and at a low temperature. These conditions are believed to result in less head-to-head linkages, which are weak polymer links and which would readily break down on irradiation.

More particularly, using para-chlorostyrene monomer for exemplification purposes, the preparation of the new class of negative resist polymers herein involves initially purifying the chlorostyrene monomer, e.g. by fractional distillation, to remove deleterious impurities. Since it is usually customary to add polymerizatiomn inhibitors, such as 3,5-di-tert-butyl catechol, to monomeric materials to prevent polymerization during storage, these inhibitors must be removed. Column chromatography, for example, using activated alumina, is one method which can be used for this purpose. Degassing of the monomer, to remove dissolved air/$O_2$, for example, by freeze-thawing under vacuum in liquid nitrogen has also been found advantageous since the presence of small amounts of oxygen in the monomer may result in oxygen being present in the backbone of the polymer, which also causes undesirable weak linkages in the chain.

The monomer is then ready to be slowly solution polymerized in accordance with the present invention. Specifically, the monomer is diluted with a low chain transfer coefficient solvent, such as for example, chlorobenzene, flurobenzene, perflurobenzene and the like and permitted to polymerize at, for example, a temperature of 60°C—100°C, for a time of, for example, from about two hours to about one month. The time for

polymerization is dependent upon several factors including temperature and/or the presence of a polymerization initiator. For instance, to obtain satisfactory polymer for the purposes of this invention, in the absence of an initiator and at temperatures of about 65°C, the polymerization is permitted to proceed for about one month. On the other hand, higher temperatures e.g. 100°C and the presence of initiator, e.g. azo compounds, such as 1,1′-bis aziosobutyronitrile, the polymerization may be terminated in about two hours.

Other initiators, which may be utilized in the solution polymerization contemplated herein, include, for example, organic peroxides, such as benzoyl peroxide, tert.-butyl-hydroperoxide, hydrogen peroxide, and peracetic acid. Generally, if used, the initiator is employed at levels of from about 0.05 to about 0.20 mole %.

After the polymerization reaction is terminated, the reaction solution is fractionated, via differential solubility of molecular weights in various solvent mixtures, to remove undesired low molecular weight polymer and to isolate the polymeric fraction having a molecular weight of from about $1 \times 10^5$ to $1 \times 10^6$ and a dispersivity of from about 1.5 to about 2.5. Solvents useful for fractionation of this sort include, for example, methyl ethyl ketone and methanol.

In forming the negative resist, the halogenated polystyrene is generally applied as a solution, such as, for example, in cyclohexanone, to a substrate, such as, for example, a silicon wafer and spin coated. To obtain the desired thickness on the support, the spin coating is usually carried out at from about 1,000 RPM to about 10,000 RPM. The coated substrate is prebaked for example at 160°C ± 5°C for about 15 minutes. Then an electron beam or other source of irradiation is caused to sweep or flood the surface of the polymer on the substrate in the desired pattern to form a negative resist by imparting sufficient energy to cross-link the polymer, thereby making the irradiated portions insoluble in certain solvents. Exposure dosages for the purposes of this invention are generally in the range of from about 1 to about 5 $\mu c/cm^2$ with electron beams, depending on the molecular weight and MWD of the polymer. With ultraviolet light (UV), the dosage is in the range of about 20—60 $mJ/cm^2$ at wavelengths from 200—260 mm. Also, with X-ray irradiation at 8—12 angstroms wavcelength, a dose of 20—60 $mJ/cm^2$ is required.

After the electron beam, UV or X-ray exposure is completed, the resist is subjected to a solvent, such as methylisobutyl ketone, 2-ethoxyethanol and the like and mixtures thereof and the non-irradiated portion of the resist is removed, thereby leaving openings in the resist that correspond to the desired pattern. If this pattern is to be RIE etched, the resist shows superior resistance due to the fact that it etches at 50% of the rate of RMMA in $CF_4$, $H_2$, $O_2$ and $CF_4$/10% $H_2$ RIE plasmas.

In order that those skilled in the art may better understand how to practice the present invention, the following examples are given by way of illustration and not by way of limitation.

### Example 1

Inhibitor (3,5-di-tert-butyl-cathecol) is removed from 4-chlorostyrene by adsorption on an activated alumina column. To a round bottom flask is added 192 ml of monomer and 350 ml of chlorobenzene (about 1/2 molar) and 0.22 g of benzoyl peroxide (0.1%). The solution is degassed by bubbling $N_2$ with stirring for two days. The flask is then heated to 65°C (± 0.5°C) with stirring, under $N_2$ for 6 days (144 hrs). After precipitation, polymer yield is 140g (~60%), Mn = 115,000, Mw = 430,000, D = 3.75.

Fractionation is effected as follows: Add 100g of the poly-4-chlorostyrene to 1000 ml methyl ethyl ketone. After dissolution, add dropwise (w/ vigorous stirring) 250 ml methanol. Stir for 2 hours after addition. Separate and precipitate the resultant two layers.

Low fraction: MN = 46,000,
Mw = 102,000,
D = 2.2

High fraction: Mn = 138,000,
Mw = 275,000,
D = 2.0

The high fraction is especially useful as a negative resist in accordance with the present invention.

### Example 2

Procedure is similar to Example 1 with the following variations. The flask contains 110 ml of 4-chlorostyrene, 200 ml chlorobenzene, and no initiator. The temperature and degas conditions are the same. Time for polymerization is 26 days. Polymer yield is 80g (~65%), Mn = 208,000, Mw = 500,000, D = 2.4.

Two fractionations are performed (as per Example 1) the highest fraction is saved. Poly-4-chlorostyrene is maintained as a 10% solution in MEK, with the following MeOH/MEK ratios: fraction #1 = 0.25; fraction #2 = 0.22. The highest fraction (#2), Mn = 390,000K, Mw = 680,000K, D = 1.75 is especially useful as a negative resist in accordance with the present invention.

### Example 3
### Preparation of Negative E-beam (UV/X-Ray Resist)

Poly(4-chlorostyrene), (high fraction), prepared in accordance with Example 1, is dissolved in cyclohexanone to produce an 11% solution. A silicon wafer (treated with a drop of hexamethyldichlorosilane) is spin coated (at about 5000 RPM) with the 11% polymer solution to obtain about 7000Å thick film after bake. The coated silicon support is prebaked at 160°C± 5°C for 15 minutes and exposed to an electron beam at a base dose of 5$\mu$coul/$cm^2$. The resist is developed by dipping the irradiated coated support in a solution of 4

parts methylisobutyl ketone (MIBK) to 3 parts 2-ethoxyethanol for at least 3 minutes, then dipping in 2-ethoxyethanol, without allowing to dry for 30 seconds and then spraying with 2-ethoxyethanol for 5 seconds. The so treated wafer is then blow dried with nitrogen gas, and the resist pattern is ready for further processing. If hardening is desired, the wafer is exposed to a deep UV source (low pressure mercury lamp), prior to the next processing step, for 3—5 minutes and is post-baked at 160—200°C.

**Claims**

1. A poly(halostyrene) having the general formula

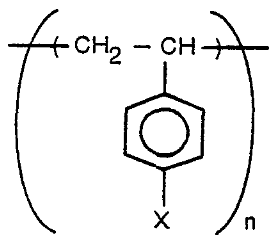

wherein X is chlorine, bromine or iodine, n represents a number in the range of from 750 to 7,500, the molecular weight (Mw) of the polymers being in the range of from $1 \times 10^5$ to $1 \times 10^6$ and the dispersivity

$$\left(\frac{Mw}{Mn}\right)$$

of the polymers being in the range of from 1.5 to 2.5, the poly(halostyrene) having been made by polymerizing halostyrene monomer in a low chain transfer coefficient solvent at a temperature in the range of from 60°C to 100°C for a time of from 2 hours to 1 month and subsequently fractionating the resulting polymer.

2. A poly(halostyrene) as claimed in claim 1, in which X is chlorine, Mw is from 250,000 to 700,000 and said dispersivity is from 1.7 to 2.2.

3. A method of preparing poly(halostyrene) having the general formula

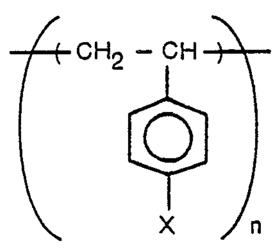

wherein X is chlorine, bromine or iodine, n represents a number in the range of from about 750 to about 7,500, the method comprising polymerizing halostyrene monomer in a low chain transfer coefficient solvent at a temperature in the range of from 60°C to 100°C for a time of from 2 hours to 1 month and subsequently isolating the polymeric fraction having a molecular weight (Mw) in the range of from $1 \times 10^5$ to $1 \times 10^6$ and a dispersivity

$$\left(\frac{Mw}{Mn}\right)$$

in the range of from 1.5 to 2.5.

4. A method as claimed in claim 3, in which said halostyrene monomer is 4-chlorostyrene.

5. A method as claimed in claim 3 or 4, in which said halostyrene monomer is degassed prior to polymerization.

6. A method as claimed in any one of claims 3 to 5, in which said low chain transfer coefficient solvent is selected from the group consisting of chlorobenzene, fluorobenzene and perfluorobenzene.

7. A method of forming a negative resist mask comprising the steps of coating a film of a poly(halostyrene) as claimed in claim 1 or 2, on a substrate, exposing said film to electron beam, X-ray or UV radiation in a predetermined pattern to cause the irradiated portion of the poly(halostyrene) to cross-link and dissolving the uncross-linked portion of said poly(halostyrene) with a solvent which dissolves and removes the uncross-linked polymer, thereby leaving said cross-linked portion of said poly(halostyrene) on said support with openings in a desired pattern.

8. A method as claimed in claim 7, in which the coated substrate is heated at a temperature in the range of from 120°C to 200°C for 15 to 60 minutes prior to exposure.

9. A method as claimed in claim 7 or 8, in which said solvent is a mixture of methylisobutyl ketone and 2-ethoxyethanol.

**Patentansprüche**

1. Ein Poly(halostyrol) nach der allgemeinen Formel

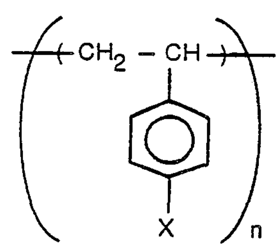

in der X Chlorin, Bromin oder Jodin ist, und n eine Zahl von ca. 750 bis ca. 7.500 darstellt, das Molekulargewicht (Mw) der Polymere im Bereich von $1 \times 10^5$ bis $1 \times 10^6$ und die Dispersität

$$\left(\frac{Mw}{Mn}\right)$$

der Polymere in Bereich von 1,5 bis 2,5 Liegt, und nach der das Poly(halostyrol) durch Polymerisierung von Halostyrolmonomer in einem Lösemittel mit niedrigem Kettentransferbeiwert in einer Temperatur von 60°C bis 100°C für eine Zeit von 2 Stunden bis 1 Monat und durch anschliessendes Fraktionieren des sich ergebenden Polymers erzielt wird.

2. Ein Poly(halostyrol) gemäss Anspruch 1, in

dem X Chlorin ist, Mw zwischen 250.000 und 700.000 liegt, und die Dispersität, 1,7 bis 2,2-beträgt.

3. Ein Poly(halostyrol) nach der allgemeinen Formel

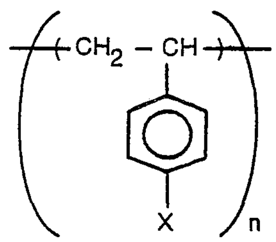

in der X Chlorin, Bromin oder Jodin ist, und n eine Zahl im Bereich von 750 bis 7.500 darstellt, und die Methode die Polymerisierung eines Halostyrolmonomers in einem Lösemittel mit niedrigem Kettentransferbeiwert in einer Temperatur von 60°C bis 100°C in einer Zeit von 2 Stunden bis 1 Monat enthält, mit anschliessender Isolierung des Polymeranteils mit einem Molekulargewicht (Mw) im Bereich von $1 \times 10^5$ bis $1 \times 10^6$ und Dispersität

$$\left(\frac{Mw}{Mn}\right)$$

im Bereich von 1,5 bis 2,5.

4. Methode gemäss Anspruch 3, in der das besagte Halostyrolmonomer 4-Chlorostyrol ist.

5. Methode gemäss Anspruch 3 oder 4, in der das besagte halostyrolmonomer vor der Polymerisierung entgast wird.

6. Methode gemäss einem der Ansprüche 3 bis 5, in der das besagte Lösemittel mit niedrigem Kettentranbsferbeiwert aus der Gruppe Chlorobenzen, Fluorobenzen und Perfluorobenzen ausgewählt wird.

7. Methode der Herstellung einer negativen Widerstandmaske, mit den Schritten des Auftragens eines Filmes aus einem Poly(halostyrol) gemäss Anspruch 1 oder 2 auf einem Substrat, der Belichtung des Films mit Elektronen-, Röntgen-oder UV-Strahlen in einem vorgegebenen Muster, sodass der bestrahlte Teil des Poly(halostyrols) Kreuzverbindungen eingeht, und Auflösung des Teiles ohne Kreuzverbindungen mit einem Lösemittel, das das Polymer ohne Kreuzverbindungen auflöst und entfernt, wodurch der besagte Anteil mit Kreuzverbindungen des besagten Poly(halostyrols) auf dem besagten Substrat verbleibt und freie Stellen in der gewünschten Anordnung enthält.

8. Methode gemäss Anspruch 7, in der das besagte beschichtete Substrat vor der Belichtung 15 bis 60 Minuten lang auf eine Temperatur von 120°C bis 200°C gebracht wird.

9. Methode gemäss Anspruch 7 oder 8, in der das besagte Lösemittel ein Gemisch aus Methylisobutyl Keton und 2-Äthoxyäthanol ist.

**Revendications**

1. Un poly(halostyrène) ayant la formule générale suivante:

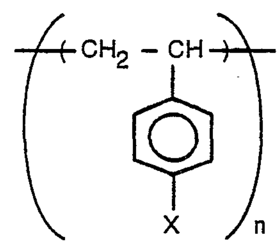

dans lequel X est du chlore, du brome ou de l'iode, n représente un nombre de l'ordre de 750 à 7500, le poids moléculaire (Mw) des polymères étant de l'ordre de $1 \times 10^5$ à $1 \times 10^6$ et la dispersivité

$$\left(\frac{Mw}{Mn}\right)$$

des polymères étant de l'ordre de 1,5 à 2,5, le poly(halostyrène) ayant été obtenu en polymérisant du monomère halostyrène dans un solvant à faible coefficient de transfert en chaîne à une température de l'ordre de 60°C à 100°C pendant une durée de 2 heures à 1 mois et en fractionnant ensuite le polymère obtenu.

2. Un poly(halostyrène) selon la revendication 1 dans lequel X est du chlore, Mw est compris entre 250000 et 700000 et ladite dispersivité est comprise entre 1,7 et 2,2.

3. Une méthode de préparation d'un poly(halostyrène) ayant la formule générale suivante:

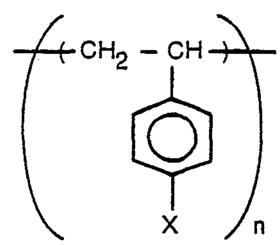

dans lequel X est du chlore, du brome ou de l'iode, n représente un nombre de l'ordre de 750 à 7500, la méthode comprenant la polymérisation de monomère halostyrène dans un solvant à faible coefficient de transfert en chaîne à une température de l'ordre de 60°C à 100°C pendant une durée de 2 heures à 1 mois et ensuite l'isolation de la fraction polymérique ayant un poids moléculaire (Mw) de l'ordre de $1 \times 10^5$ à $1 \times 10^6$ et une dispersivité

$$\left(\frac{Mw}{Mn}\right)$$

de l'ordre de 1,5 à 2,5.

4. Une méthode selon la revendication 3 dans laquelle ledit monomère halostyrène est du 4-chlorostyrène.

5. une méthode selon la revendication 3 ou 4 dans laquelle ledit monomère halostyrène est dégazé avant polymérisation.

6. Une méthode selon l'une quelconque des revendications 3 à 5 dans laquelle ledit solvant à faible coefficient de transfert en chaîne est choisi dans le groupe composé du chlorobenzène, du fluorobenzène et du perfluorobenzène.

7. Une méthode de formation d'une mesque de résist négatif comprenant les étapes d'application d'un film d'un poly(halostyrène) selon la revendication 1 ou 2 sur un substrat, d'exposition dudit film à un faisceau d'électrons, aux rayons X ou à une radiation UV dans une configuration prédéterminée pour que la partie irradiée du poly(halostyrène) provoque la liaison transversale et la dissolution de la partie sans liaisons transversales dudit poly(halostyrène) avec un solvant qui dissout et retire le polymère sans liaisons transversales, ce qui laisse ladite partie comportant des liaisons transversales dudit poly(halostyrène) sur ledit support avec des ouvertures selon une configuration désirée.

8. Une méthode selon la revendication 7 dans laquelle le substrat revêtu est chauffé à une température de l'ordre de 120°C à 200°C pendant 15 à 60 minutes avant exposition.

9. Une méthode selon la revendication 7 ou 8 dans laquelle ledit solvant est un mélange de méthylisobutyle cétone et de 2-éthoxyéthanol.

FIG. 1

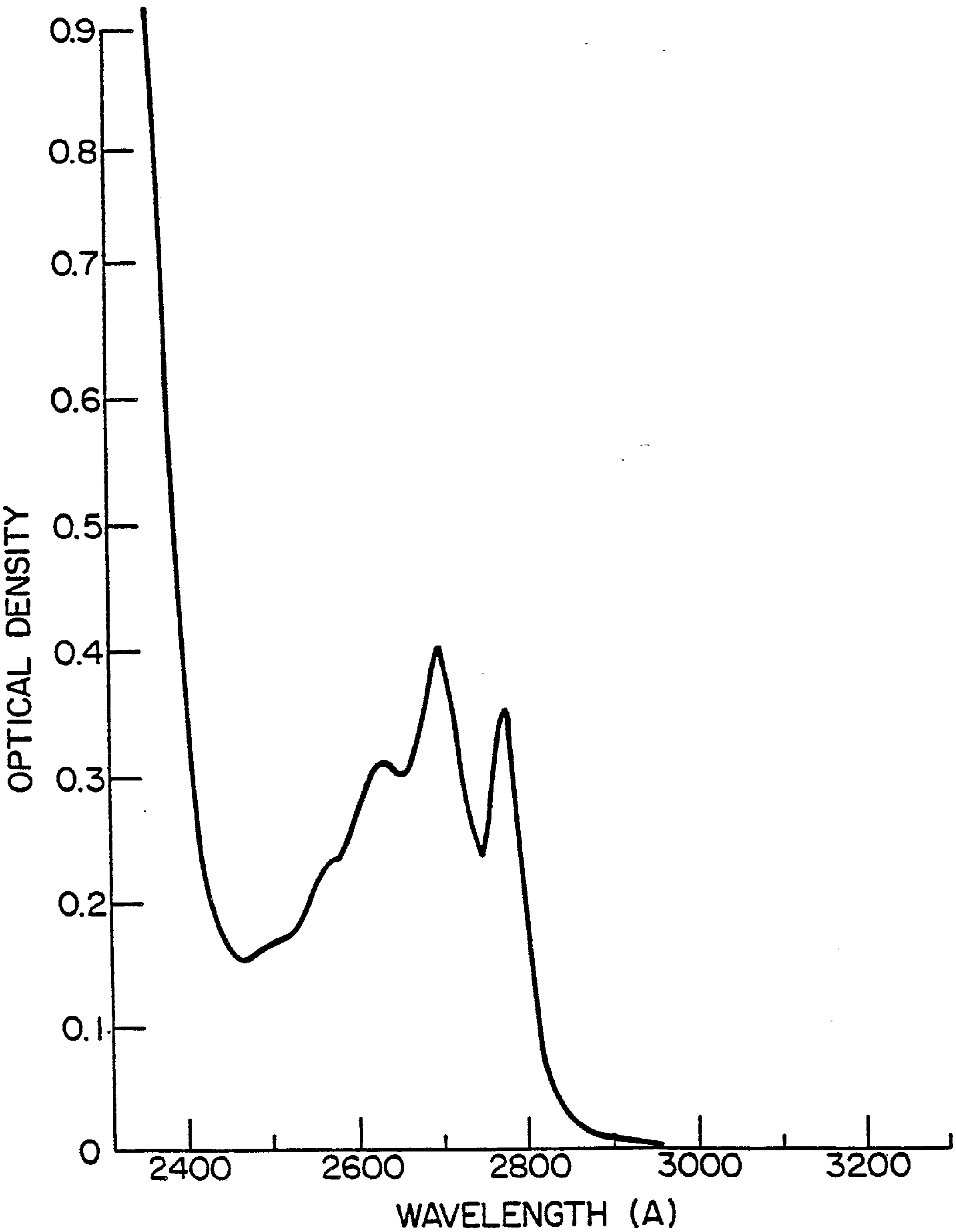
0.9
0.8
0.7
0.6
0.5
0.4
0.3
0.2
0.1
0
OPTICAL DENSITY
2400
2600
2800
3000
3200
WAVELENGTH (A)

FIG. 2.1

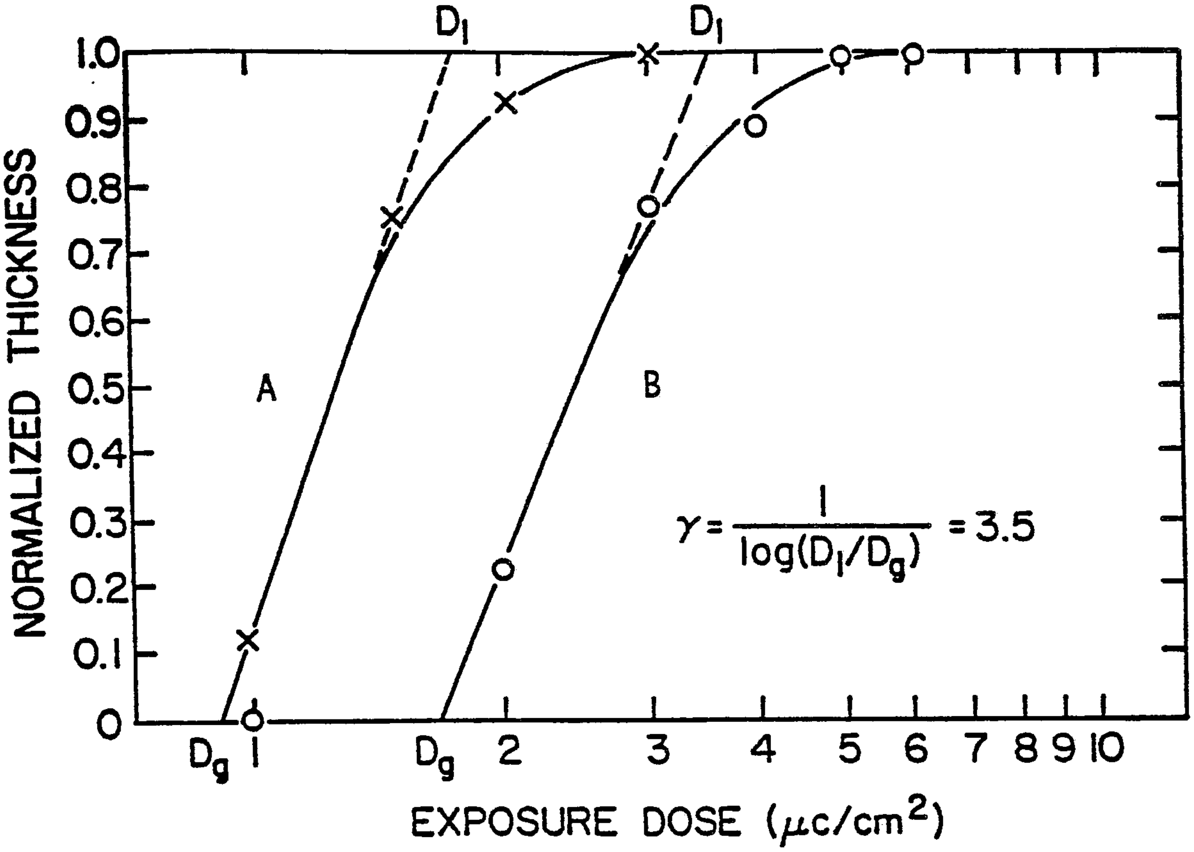
D1
D1
1.0
0.9
0.8
0.7
0.6
0.5
0.4
0.3
0.2
0.1
0
NORMALIZED THICKNESS
A
B
γ = 1 / log(D1/Dg) = 3.5
Dg 1
Dg 2
3
4
5
6
7
8
9
10
EXPOSURE DOSE (μc/cm2)

FIG. 2.2

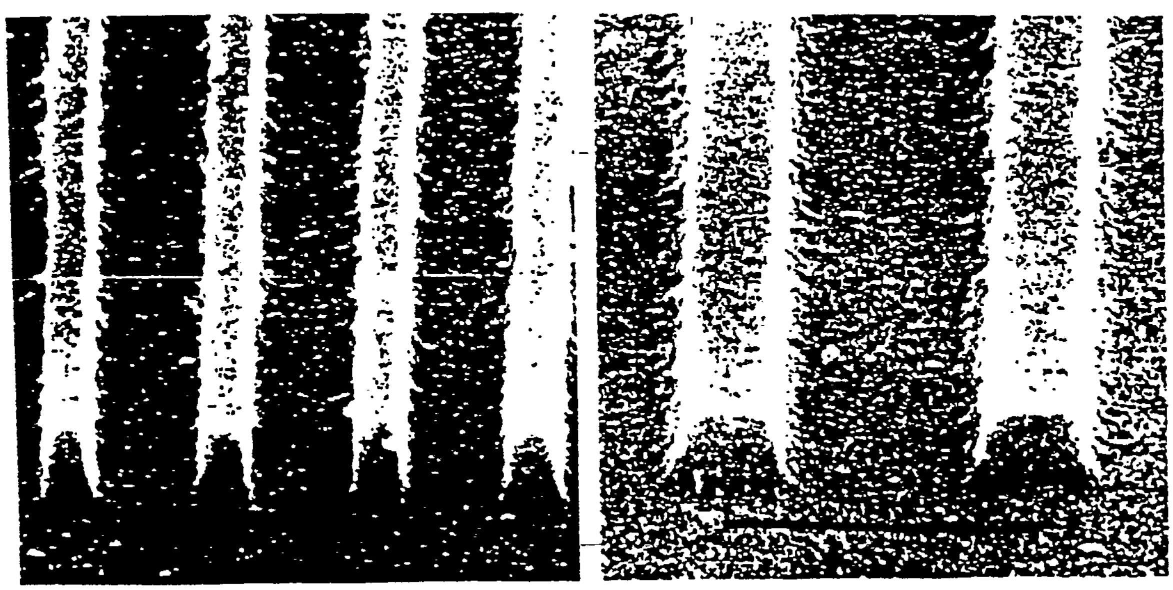

FIG. 3

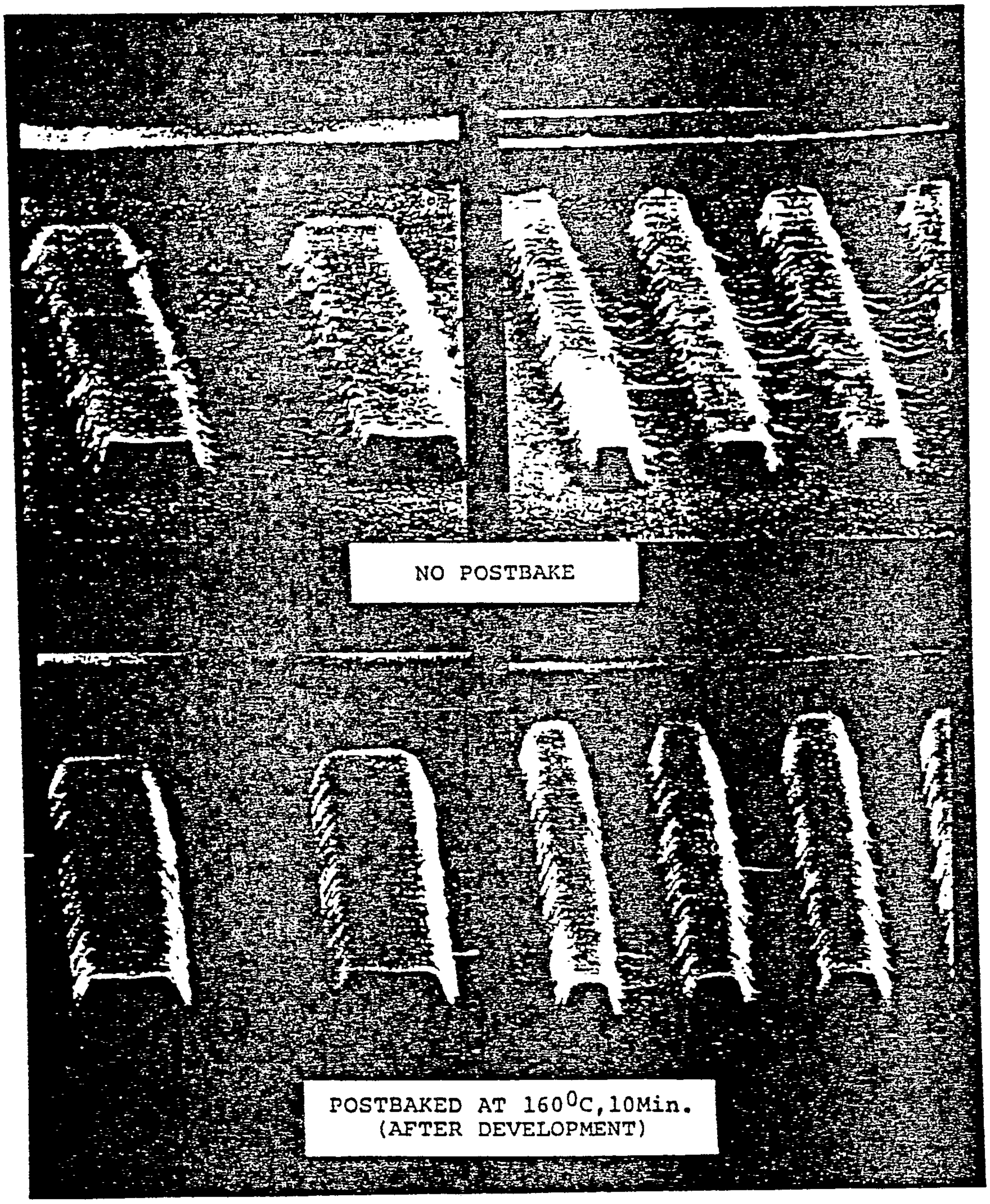

FIG. 4

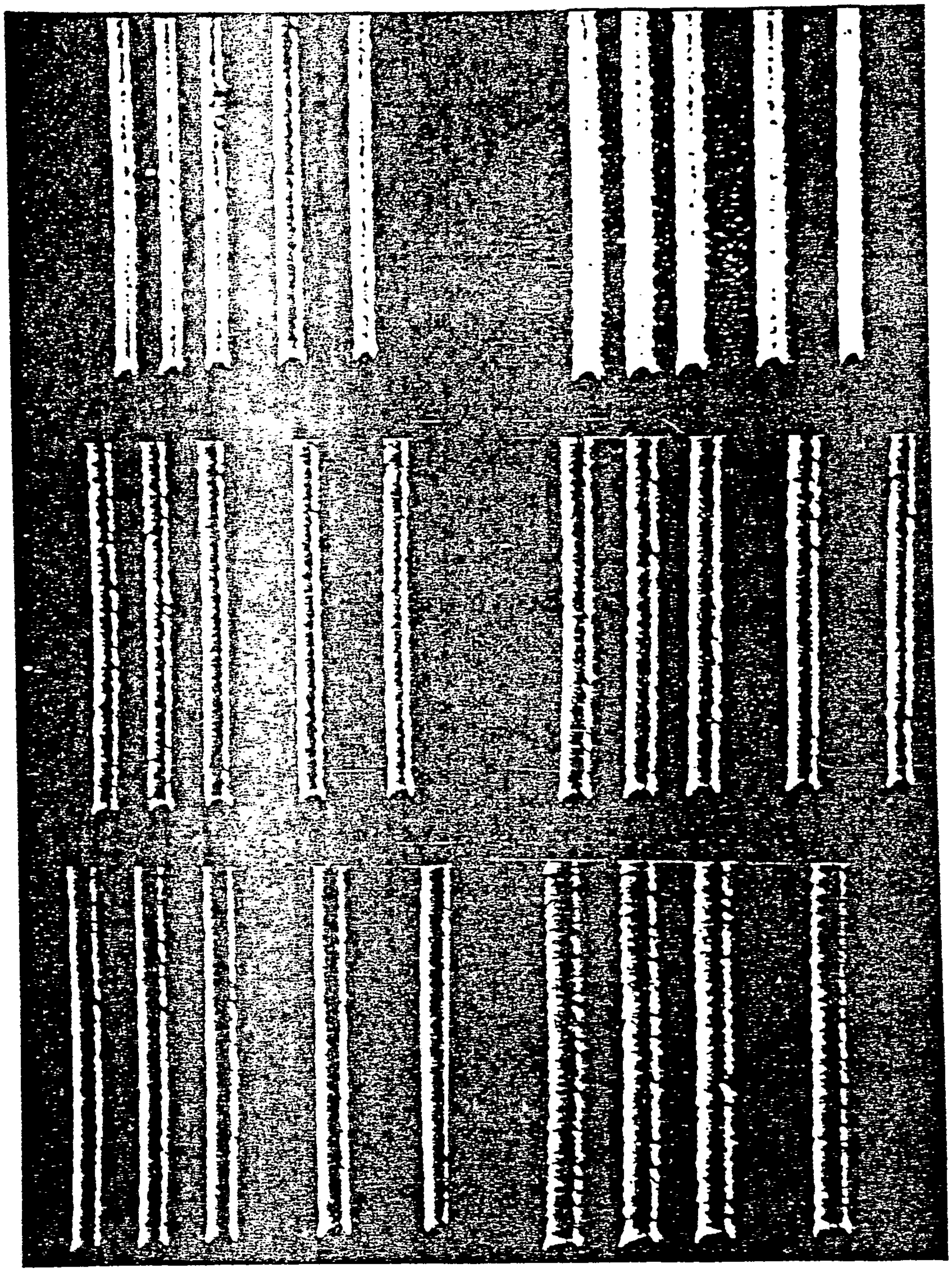

FIG. 5.1

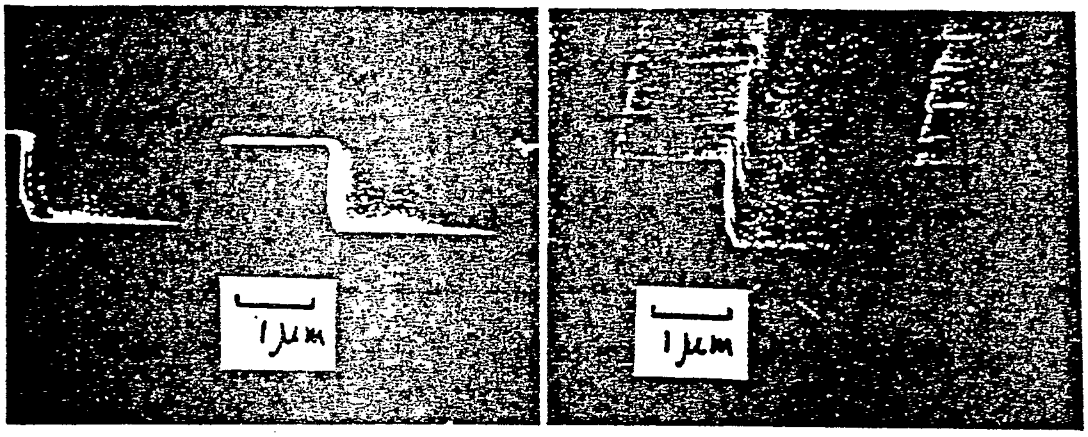


FIG. 5.2